(19) Europäisches Patentamt / European Patent Office / Office européen des brevets

(11) **EP 3 088 485 B1**

(12) **EUROPEAN PATENT SPECIFICATION**

(45) Date of publication and mention
of the grant of the patent:
**12.08.2020 Bulletin 2020/33**

(21) Application number: **14873776.0**

(22) Date of filing: **17.12.2014**

(51) Int Cl.:
*C09K 3/10* (2006.01)  *B32B 7/02* (2019.01)
*C08J 5/18* (2006.01)  *H01L 51/50* (2006.01)
*H05B 33/04* (2006.01)

(86) International application number:
**PCT/JP2014/083391**

(87) International publication number:
**WO 2015/098647 (02.07.2015 Gazette 2015/26)**

(54) **SHEET-LIKE SEALING MATERIAL, SEALING SHEET, ELECTRONIC-DEVICE SEALING BODY, AND ORGANIC ELECTROLUMINESCENT ELEMENT**

BAHNFÖRMIGES DICHTUNGSMATERIAL, DICHTUNGSBAHN, DICHTUNGSKÖRPER FÜR ELEKTRONISCHE VORRICHTUNG UND ORGANISCHES ELEKTROLUMINESZENZELEMENT

MATÉRIAU D'ÉTANCHÉITÉ DE TYPE FEUILLE, FEUILLE D'ÉTANCHÉITÉ, CORPS ÉTANCHÉIFIÉ DE DISPOSITIF ÉLECTRONIQUE ET ÉLÉMENT ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.12.2013 JP 2013268519**

(43) Date of publication of application:
**02.11.2016 Bulletin 2016/44**

(73) Proprietor: **LINTEC Corporation**
**Tokyo 173-0001 (JP)**

(72) Inventors:
• **HAGIHARA Yoshiaki**
**Tokyo 173-0001 (JP)**
• **NISHIJIMA Kenta**
**Tokyo 173-0001 (JP)**

(74) Representative: **Beckmann, Claus**
**Kraus & Weisert**
**Patentanwälte PartGmbB**
**Thomas-Wimmer-Ring 15**
**80539 München (DE)**

(56) References cited:
**EP-A1- 2 737 997      WO-A1-2010/061738**
**WO-A1-2012/039436    JP-A- H06 172 742**
**JP-A- 2006 297 737**

• **DATABASE WPI Week 201377 Thomson Scientific, London, GB; AN 2013-U88329 XP002772554, & WO 2013/168715 A1 (MITSUBISHI PLASTICS INC) 14 November 2013 (2013-11-14)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

The present invention relates to a sheet-like sealing material that exhibits an excellent water barrier capability, excellent light resistance, excellent colorlessness, and excellent transparency, a sealing sheet that includes the sheet-like sealing material and a gas barrier layer, a sealed electronic device that is obtained using the sheet-like sealing material or the sealing sheet as a sealing material, and an organic EL device that includes the sheet-like sealing material.

BACKGROUND ART

In recent years, an organic EL device has attracted attention as a light-emitting device that can emit light with high luminance (brightness) through low-voltage DC drive.

However, the organic EL device has a problem in that the emission properties (e.g., luminance, luminous efficiency, and luminous uniformity) easily deteriorate with the passing of time.

It is considered that deterioration in the emission properties of the organic EL device occurs when oxygen, water, and the like enter the organic EL device, and cause the electrode and the organic layer to deteriorate. In order to solve this problem, several methods that utilize a sealing material have been proposed.

For example, Patent Literature 1 discloses an organic EL device having a configuration in which an organic EL layer that is provided on a glass substrate and placed between a transparent electrode and a bottom electrode (that are formed in the shape of a thin film) is covered with a photocurable resin layer (sealing material) that exhibits humidity resistance. Patent Literature 2 discloses a method that seals an organic EL device using a sealing film that is formed using a moisture-proof polymer film and an adhesive layer.

An acrylic-based adhesive and an acrylic-based pressure-sensitive adhesive (hereinafter referred to as "acrylic-based adhesive and the like") are known as an adhesive and a pressure-sensitive adhesive that are used as a sealing material for sealing an organic EL device taking account of optical properties (e.g., transparency).

For example, Patent Literature 3 discloses a UV-curable acrylic-based adhesive that can be cured at room temperature as a sealing material for sealing an organic EL display.

Patent Literature 4 discloses an acrylic-based pressure-sensitive adhesive as a pressure-sensitive adhesive that can form a pressure-sensitive adhesive layer that allows light emitted from an organic EL display device to propagate to the surface of the display with excellent propagation efficiency even after being heated.

In recent years, an adhesive that includes a polyisobutylene-based resin has been proposed as a sealing adhesive that exhibits a good water barrier capability. For example, Patent Literature 5 discloses an adhesive composition that is used as a sealing material for sealing an organic EL display, and includes a specific hydrogenated cycloolefin-based polymer and a polyisobutylene resin.

The organic EL device also has a problem in that the organic layer (e.g., emitting layer) easily deteriorates due to ultraviolet rays. In order to solve this problem, Patent Literature 6 proposes an organic EL device in which the organic EL layer is covered with a resin layer that includes a UV absorber.

WO 2013/168715 A1 describes a laminated gas barrier film which is said to have outstanding optical characteristics while having adequate gas barrier properties, and excellent producibility. The gas barrier film comprises on at least one surface of a base material an inorganic layer which is formed by means of vacuum deposition, the inorganic layer which is formed by means of vacuum deposition being formed by using heat to vaporize a vaporization material that is formed by sintering and molding an inorganic powder having a median diameter of 3-100 $\mu$m into a cylindrical shape whereof the diameter is 10-45% of the inner diameter at the bottom part of a crucible and the height is no greater than 45% of the internal height of the crucible.

WO 2012/039436 A1 describes a film sealant that is effective in ensuring a close seal of electronic devices at low temperatures. At least part of a device is covered with a film-form sealant containing a copolymer polyamide resin; then the sealant is hot-melted then cooled, thereby covering and sealing the device. The melting point or softening point of the copolymer polyamide resin falls within the range of 75 to 160°C, and the resin may have crystalline properties. The copolymer polyamide resin may be a multi-component copolymer, or contain units derived from long-chain components having an C8-16 aklyene group (C9-17 lactam and amino C9-17 alkane carboxylic acid, etc.). The film sealant may cover only one surface of a device.

WO 2010/061738 A1 describes a film for a backside sealing sheet for solar cells, which is said to have excellent light resistance and partial discharge voltage that serves as an index for electrical insulation. The film for a backside sealing sheet for solar cells is characterized in that a resin layer, which contains an antistatic agent and a resin that is obtained by copolymerizing an acrylic polyol resin with an ultraviolet absorbent and a light stabilizer, is arranged on at least one surface of a base film, and that the amount of the antistatic agent contained in the resin layer is 1-30 parts by mass per 100 parts by mass of the resin that is obtained by copolymerizing an acrylic polyol resin with an ultraviolet absorbent and a light stabilizer.

JP 2006-297737 A relates to the problem to provide a plastic film having high barrier properties, transparency, and an ultraviolet cutoff function. As a solution to the problem, the document describes a gas-barrier film which comprises at least one gas-barrier layer of an inorganic compound formed on a transparent, flexible support substrate, wherein the water vapor transmittance at 40 °C and in relative humidity 90 % of the film is 0.005 $g/m^2$/day or below, and the ultraviolet transmittance of wavelength 350 nm is 10 % or below.

JP H06-172742 A relates to the problem to obtain an adsorber composition which is excellent in ultraviolet absorptivity in a wavelength region of 300-400 nm and hardly allows the phase separation of an ultraviolet absorber by compounding a specific benzotriazole compound as the absorber into the composition. As a solution to the problem, the document describes an absorber composition which contains, as the ultraviolet absorber, a benzotriazole compound, preferably 2-[2'-hydroxy-5'-(beta-methacryloyloxy)-3'-t-butylphenyl]-5-butyl-2H-benzotriazole. A preferred useful composition contains a copolymer of the absorber with another copolymrizable unsaturated monomer, such as styrene, a compound having a silicon atom and a double bond, or a (meth)acrylic ester. This composition is useful for optical materials, especially for an intraocular lens, a contact lens, and an ophthalmic lens.

EP 2 737 997 A1 describes a gas barrier film laminate comprising at least two gas barrier films and a pressure-sensitive adhesive layer, the at least two gas barrier films being stacked through the pressure-sensitive adhesive layer, at least one of the at least two gas barrier films including a base formed of a plastic film, and at least one gas barrier layer provided on the base, and the pressure-sensitive adhesive layer being a layer formed using a rubber-based pressure-sensitive adhesive composition that includes a rubber-based compound. The document also describes an electronic member comprising the gas barrier film laminate. The gas barrier film laminate exhibits a high water vapor barrier capability, and does not show interfacial lifting at the end thereof.

CITATION LIST

PATENT LITERATURE

Patent Literature 1: JP-A-5-182759

Patent Literature 2: JP-A-5-101884

Patent Literature 3: JP-A-2004-87153

Patent Literature 4: JP-A-2004-224991

Patent Literature 5: JP-T-2009-524705 (WO2007/087281)

Patent Literature 6: JP-A-2009-37809 (US2010/0244073A1)

SUMMARY OF INVENTION

TECHNICAL PROBLEM

When the organic EL layer is sealed using a resin layer that includes a UV absorber (see Patent Literature 6), and the content of the UV absorber is increased in order to improve the light resistance, the resin layer may yellow, whereby the hue of the light emitted from the organic EL device may change, or the transparency of the resin layer may deteriorate, whereby the luminance of the organic EL device may decrease.

The invention was conceived in view of the above situation. An object of the invention is to provide a sheet-like sealing material that exhibits an excellent water barrier capability, excellent light resistance, excellent colorlessness, and excellent transparency, a sealing sheet that includes the sheet-like sealing material and a gas barrier layer, a sealed electronic device that is obtained using the sheet-like sealing material or the sealing sheet as a sealing material, and an organic EL device that includes the sheet-like sealing material.

SOLUTION TO PROBLEM

The inventors of the invention conducted extensive studies in order to solve the above problem. As a result, the inventors found that a sheet-like sealing material having a low water vapor transmission rate, having a b* value (in the CIE L*a*b* color system defined by JIS Z 8729-1994) within a specific range, having low light transmittance at a wavelength of 370 nm, and having high light transmittance at a wavelength of 420 nm, exhibits an excellent water barrier capability, excellent light resistance, excellent colorlessness, and excellent transparency. This finding has led to the completion of the invention.

Several aspects of the invention provide the following sheet-like sealing material (see (1) to (3)), sealing sheet (see (4) to (6)), sealed electronic device (see (7)), and organic EL device (see (8)).

(1) A sheet-like sealing material including one sealing resin layer, or two or more sealing resin layers, the sheet-like sealing material having a water vapor transmission rate at a temperature of 40 °C and a relative humidity of 90 % of 20 g/(m$^2$·day) or less when the sheet-like sealing material has a thickness of 50 μm, having a b* value in a CIE L*a*b* color system defined by JIS Z 8729-1994 of -2 to 2, having a light transmittance at a wavelength of 370 nm of 1 % or less, and having a light transmittance at a wavelength of 420 nm of 85 % or more, wherein the sheet-like sealing material is (i) a sheet-like sealing material consisting of one sealing resin layer, (ii) a sheet-like sealing material consisting of one sealing resin layer and one or two release sheets, (iii) a sheet-like sealing material consisting of two or more sealing resin layers, or (iv) a sheet-like sealing material consisting of two or more sealing resin layers and one or two release sheets, the sheet-like sealing material has a thickness of 0.1 to 100 μm, the sheet-like sealing material has an adhesion to glass at a temperature of 23 °C and a relative humidity of 50 % of 3 N/25 mm or more, the sealing resin layer comprises at least one material selected from the group consisting of a rubber-based polymer and a polyolefin-based polymer, and at least one of the sealing resin layers comprises a UV absorber.

(2) The sheet-like sealing material according to (1), wherein the UV absorber has a maximum absorption wavelength within the range from 330 to 370 nm.

(3) The sheet-like sealing material according to (1), the sheet-like sealing material being used to seal an electronic device.

(4) A sealing sheet including a sheet-like sealing material that includes one sealing resin layer, or two or more sealing resin layers, and a gas barrier layer, the sheet-like sealing material being the sheet-like sealing material according to (1).

(5) The sealing sheet according to (4), including the sheet-like sealing material, and a gas barrier film in which the gas barrier layer is formed on a base film either directly or through an additional layer.

(6) The sealing sheet according to (4), the sealing sheet being used to seal an electronic device.

(7) A sealed electronic device including the sheet-like sealing material according to (1), or the sealing sheet according to (4), and an electronic device that is sealed with the sheet-like sealing material or the sealing sheet.

(8) An organic EL device including a transparent substrate, a first electrode, an organic EL layer, a second electrode, a sheet-like sealing material that includes one sealing resin layer, or two or more sealing resin layers, and a sealing base, the first electrode, the organic EL layer, the second electrode, the sheet-like sealing material, and the sealing base being sequentially stacked on the transparent substrate, the sheet-like sealing material being the sheet-like sealing material according to (1).

ADVANTAGEOUS EFFECTS OF INVENTION

The aspects of the invention thus provide a sheet-like sealing material that exhibits an excellent water barrier capability, excellent light resistance, excellent colorlessness, and excellent transparency, a sealing sheet that includes the sheet-like sealing material and a gas barrier layer, a sealed electronic device that is obtained using the sheet-like sealing material or the sealing sheet as a sealing material, and an organic EL device that includes the sheet-like sealing material.

A sheet-like sealing material, a sealing sheet, a sealed electronic device, and an organic EL device according to the exemplary embodiments of the invention are described in detail below.

1) Sheet-like sealing material

A sheet-like sealing material according to one embodiment of the invention includes one sealing resin layer, or two or more sealing resin layers, the sheet-like sealing material having a water vapor transmission rate at a temperature of 40 °C and a relative humidity of 90 % of 20 g/(m²·day) or less when the sheet-like sealing material has a thickness of 50 μm, having a b* value in a CIE L*a*b* color system defined by JIS Z 8729-1994 of -2 to 2, having a light transmittance at a wavelength of 370 nm of 1 % or less, and having a light transmittance at a wavelength of 420 nm of 85 % or more, wherein the sheet-like sealing material is (i) a sheet-like sealing material consisting of one sealing resin layer, (ii) a sheet-like sealing material consisting of one sealing resin layer and one or two release sheets, (iii) a sheet-like sealing material consisting of two or more sealing resin layers, or (iv) a sheet-like sealing material consisting of two or more sealing resin layers and one or two release sheets, the sheet-like sealing material has a thickness of 0.1 to 100 μm, the sheet-like sealing material has an adhesion to glass at a temperature of 23 °C and a relative humidity of 50 % of 3 N/25 mm or more, the sealing resin layer comprises at least one material selected from the group consisting of a rubber-based polymer and a polyolefin-based polymer, and at least one of the sealing resin layers comprises a UV absorber.

The sheet-like sealing material according to one embodiment of the invention has a water vapor transmission rate at a temperature of 40 °C and a relative humidity of 90 % of 20 g/(m²·day) or less, preferably 10 g/(m²·day) or less, more preferably 8 g/(m²·day) or less, and still more preferably 5 g/(m²·day) or less, when the sheet-like sealing material has a thickness of 50 μm. The lower limit of the water vapor transmission rate is not particularly limited, and is preferably as small as possible. The lower limit of the water vapor transmission rate is normally 0.1 g/(m²·day) or more.

When the water vapor transmission rate is within the above range, it is possible to sufficiently reduce or suppress entry of water. Such a sheet-like sealing material may suitably be used as a sealing material for sealing an electronic device.

The water vapor transmission rate of the sheet-like sealing material depends on the thickness of the sheet-like sealing material. When the thickness of the sheet-like sealing material is not 50 μm, the water vapor transmission rate of the sheet-like sealing material is converted using the thickness of the sheet-like sealing material to calculate the water vapor transmission rate of the sheet-like sealing material when the sheet-like sealing material has a thickness of 50 μm. For example, when the thickness of the sheet-like sealing material is A μm, and the water vapor transmission rate of the sheet-like sealing material is B g/(m²·day), the water vapor transmission rate of the sheet-like sealing material when the sheet-like sealing material has a thickness of 50 μm is calculated using the expression "A×B/50".

The water vapor transmission rate can be controlled by appropriately selecting the sealing resin used to produce the sheet-like sealing material. For example, a sheet-like sealing material having a low water vapor transmission rate can be obtained by increasing the content of a rubber-based polymer in the sealing resin layer (as described later).

The water vapor transmission rate may be measured using the method described later in connection with the examples.

The sheet-like sealing material according to one embodiment of the invention has a b* value in the CIE L*a*b* color system defined by JIS Z 8729-1994 of -2 to 2, preferably -1.5 to 1.5, more preferably -1.0 to 1.0, and particularly preferably -0.5 to 0.5.

The b* value represents the degree of yellow-blue when the color is converted into a numerical value. Specifically, a positive b* value indicates yellow, and a negative b* value indicates blue.

When the b* value is within the above range, the sheet-like sealing material exhibits excellent colorlessness. Such a sheet-like sealing material may suitably be used as a sealing material for sealing a light-emitting device.

The b* value can be controlled by appropriately selecting the sealing resin used to produce the sheet-like sealing material, and an additional component. When a UV absorber is added to the sealing resin layer, the b* value may increase depending on the type and the content of the UV absorber. Therefore, it is important to appropriately select the type and the content of the UV absorber.

Specifically, the b* value can be controlled by selecting the UV absorber using the light transmittance at a wavelength of 420 nm as an index, and appropriately determining the content of the UV absorber, the thickness of the sheet-like sealing material, and the like (as described later).

The sheet-like sealing material according to one embodiment of the invention preferably has an a* value in the CIE L*a*b* color system defined by JIS Z 8729-1994 of -2 to 2, more preferably -1.5 to 1.5, still more preferably -1.0 to 1.0, and particularly preferably -0.5 to 0.5.

The a* value represents the degree of red-green when the color is converted into a numerical value. Specifically, a positive a* value indicates red, and a negative a* value indicates green.

When the a* value is within the above range, the sheet-like sealing material exhibits excellent colorlessness. Such a sheet-like sealing material may suitably be used as a sealing material for sealing a light-emitting device.

The a* value can be controlled by appropriately selecting the sealing resin used to produce the sheet-like sealing material, and an additional component.

The b* value and the a* value in the CIE L*a*b* color system defined by JIS Z 8729-1994 may be measured using the method described later in connection with the examples.

The sheet-like sealing material according to one embodiment of the invention has a light transmittance at a wavelength of 370 nm of 1 % or less, and preferably 0.5 % or less. The sheet-like sealing material according to one embodiment of the invention has a light transmittance at a wavelength of 420 nm of 85 % or more, and preferably 90 % or more. The light transmittance may be measured using the method described later in connection with the examples.

When the sheet-like sealing material has a light transmittance at a wavelength of 370 nm of 1 % or less, the sheet-like sealing material can sufficiently absorb ultraviolet rays, and exhibits excellent light resistance. Such a sheet-like sealing material may suitably be used as a sealing material for sealing an organic EL layer and the like that easily deteriorate due to ultraviolet rays.

The light transmittance at a wavelength of 370 nm can be decreased by adding a UV absorber to at least one sealing resin layer, for example. In particular, the light transmittance at a wavelength of 370 nm can be controlled to be 1 % or less by appropriately determining the content of the UV absorber and the thickness of the sheet-like sealing material taking account of the maximum absorption wavelength and the absorption coefficient of the UV absorber.

When the sheet-like sealing material has a light transmittance at a wavelength of 420 nm of 85 % or more, the b* value easily falls within the above range, and the sheet-like sealing material exhibits excellent colorlessness and excellent transparency.

When an additive (e.g., UV absorber) that may absorb visible light is used, the light transmittance at a wavelength of 420 nm can be controlled to be 85 % or more by appropriately determining the content of the additive and the thickness of the sheet-like sealing material, for example.

The thickness of the sheet-like sealing material according to one embodiment of the invention is 0.1 to 100 $\mu$m, preferably 5 to 90 $\mu$m, and more preferably 10 to 80 $\mu$m.

When the thickness of the sheet-like sealing material is within the above range, it is possible to easily obtain a sealing material that exhibits a water barrier capability, light resistance, colorlessness, and transparency in a well-balanced manner.

The adhesion of the sheet-like sealing material according to one embodiment of the invention may be evaluated by subjecting the sheet-like sealing material to a 180° peel test. More specifically, when the sheet-like sealing material having a width of 25 mm is bonded to glass at a temperature of 23 °C and a relative humidity of 50 %, allowed to stand for 24 hours, and subjected to a tensile test using a tensile tester at a tensile rate of 300 mm/min and a peel angle of 180°, the sheet-like sealing material has an adhesion of 3 N/25 mm or more.

Such a sheet-like sealing material can reliably prevent a situation in which entry of water and the like occurs at the interface between the sheet-like sealing material and the sealing target.

The adhesion of the sheet-like sealing material can be controlled by appropriately selecting the type of sealing resin and the type of additive, or forming a cross-linked structure in the sealing resin layer, for example.

The sealing resin layer included in the sheet-like sealing material according to one embodiment of the invention is a layer that includes a sealing resin.

The term "rubber-based polymer" used herein refers to a polymer (e.g., natural rubber or synthetic rubber) that exhibits rubber elasticity. Examples of the rubber-based polymer include a natural rubber (NR), a butadiene homopolymer (butadiene rubber (BR)), a chloroprene homopolymer (chloroprene rubber (CR)), an isoprene homopolymer, an acrylonitrile-butadiene copolymer (nitrile rubber), an ethylene-propylene-non-conjugated diene ternary copolymer, an isobutylene-based polymer, modified products thereof, and the like. Among these, an isobutylene-based polymer is preferable.

The term "isobutylene-based polymer" used herein refers to a polymer that includes a repeating unit derived from isobutylene in either or both of the main chain and the side chain. The content of the repeating unit derived from isobutylene in the isobutylene-based polymer is preferably 50 mass-% or more, more preferably 60 mass-% or more, and still more preferably 70 to 99 mass-%.

Examples of the isobutylene-based polymer include an isobutylene homopolymer (polyisobutylene), an isobutylene-isoprene copolymer (butyl rubber), an isobutylene-n-butene copolymer, an isobutylene-butadiene copolymer, halogenated copolymers obtained by brominating or chlorinating these polymers, and the like. Among these, an isobutylene-isoprene copolymer (butyl rubber) is preferable.

The term "(meth)acrylic-based polymer" used herein refers to a polymer that includes a repeating unit derived from a (meth)acrylic-based monomer in either or both of the main chain and the side chain. Examples of the (meth)acrylic-based polymer include a homopolymer and a copolymer of a (meth)acrylic-based monomer, modified products thereof, and the like. Note that the term "(meth)acrylic" used herein refers to "acrylic" or "methacrylic" (hereinafter the same).

The content of the repeating unit derived from the (meth)acrylic-based monomer in the (meth)acrylic-based polymer is preferably 50 mass-% or more, more preferably 60 mass-% or more, and still more preferably 70 to 99 mass-%.

Examples of the (meth)acrylic-based monomer include (meth)acrylic acid, an alkyl (meth)acrylate in which with the alkyl group has 1 to 20 carbon atoms, such as methyl (meth)acrylate, ethyl (meth)acrylate, propyl (meth)acrylate, and butyl (meth)acrylate, and a (meth)acrylate that includes a reactive functional group, such as 2-ethylhexyl (meth)acrylate and hydroxymethyl (meth)acrylate.

The term "polyolefin-based polymer" used herein refers to a polymer that includes a repeating unit derived from an olefin-based monomer in either or both of the main chain and the side chain. Examples of the polyolefin-based polymer include a homopolymer and a copolymer of an olefin-based monomer, modified products thereof, and the like.

Examples of the olefin-based monomer include ethylene; an α-olefm having 3 to 20 carbon atoms, such as propylene, 1-butene, 4-methyl-1-pentene, 3-methyl-1-butene, 1-hexene, and 1-octene; a cycloolefin having 4 to 20 carbon atoms, such as cyclobutene, tetracyclododecene, and norbornene; modified products thereof; and the like.

The term "polyester-based polymer" used herein refers to a polymer obtained by the polycondensation of a polycarboxylic acid and a polyol, or a modified product thereof.

Examples of the polycarboxylic acid include terephthalic acid, isophthalic acid, o-phthalic acid, succinic acid, adipic acid, sebacic acid, cyclohexanedicarboxylic acid, trimellitic acid, and the like. Examples of the polyol include an aliphatic alcohol such as ethylene glycol and propylene glycol, and a polyether polyol such as polyethylene glycol and polypropylene glycol.

The term "silicone-based polymer" used herein refers to a polymer that includes a (poly)siloxane structure in either or both of the main chain and the side chain, or a modified product thereof.

Examples of the silicone-based polymer include dimethylpolysiloxane, methylphenylpolysiloxane, methyl hydrogen polysiloxane, and the like.

The term "styrene-based thermoplastic elastomer" used herein refers to a polymer that includes a repeating unit derived from styrene, or a modified product thereof. Examples of the styrene-based thermoplastic elastomer include a styrene-butadiene-styrene block copolymer (SBS), a styrene-ethylene-butene-styrene block copolymer (SEBS) (i.e., hydrogenated SBS), a styrene-isoprene-styrene block copolymer (SIS), a styrene-ethylene-propylene-styrene block copolymer (SEPS) (i.e., hydrogenated SIS), a styrene-butadiene copolymer (styrene-butadiene rubber (SBR)), a styrene-isoprene copolymer, a styrene-isobutylene diblock copolymer (SIB), a styrene-isobutylene-styrene triblock copolymer (SIBS), and the like.

These sealing resins may be used either alone or in combination.

The rubber-based polymer or the polyolefin-based polymer are used as the sealing resin since a sheet-like sealing material having a low water vapor transmission rate can be easily obtained.

The number average molecular weight (Mn) of the sealing resin is preferably 100,000 to 2,000,000, more preferably 100,000 to 1,500,000, and still more preferably 100,000 to 1,000,000.

When the number average molecular weight (Mn) of the sealing resin is within the above range, a sheet-like sealing material having a low water vapor transmission rate can be easily obtained.

The number average molecular weight (Mn) of the sealing resin refers to a standard polystyrene-equivalent value determined by gel permeation chromatography using tetrahydrofuran as a solvent.

A cross-linked structure may be formed in the sealing resin layer. When a cross-linked structure is formed in the sealing resin layer, the sealing resin layer exhibits sufficient cohesive strength, more excellent adhesion, and a lower water vapor transmission rate.

A cross-linked structure may be formed in the sealing resin layer using a known cross-linked structure-forming method used for an adhesive and the like.

For example, when a sealing resin that includes a hydroxyl group or a carboxyl group is used, a cross-linked structure may be formed using a cross-linking agent such as an isocyanate-based cross-linking agent, an epoxy-based cross-linking agent, an aziridine-based cross-linking agent, or a metal chelate-based cross-linking agent.

The term "isocyanate-based cross-linking agent" used herein refers to a compound that includes an isocyanate group as a cross-linkable group.

Examples of the isocyanate-based cross-linking agent include an aromatic polyisocyanate such as trimethylolpropane-modified tolylene diisocyanate, tolylene diisocyanate, diphenylmethane diisocyanate, and xylylene diisocyanate; an aliphatic polyisocyanate such as hexamethylene diisocyanate; an alicyclic polyisocyanate such as isophorone diisocyanate and hydrogenated diphenylmethane diisocyanate; biuret products, isocyanurate products, and adducts (i.e., reaction products with a low-molecular-weight active hydrogen-containing compound (e.g., ethylene glycol, propylene glycol, neopentyl glycol, trimethylolpropane, or castor oil)) thereof; and the like.

The term "epoxy-based cross-linking agent" used herein refers to a compound that includes an epoxy group as a cross-linkable group.

Examples of the epoxy-based cross-linking agent include 1,3-bis(N,N'-diglycidylaminomethyl)cyclohexane, N,N,N',N'-tetraglycidyl-m-xylylenediamine, ethylene glycol diglycidyl ether, 1,6-hexanediol diglycidyl ether, trimethylolpropane diglycidyl ether, diglycidylaniline, diglycidylamine, and the like.

The term "aziridine-based cross-linking agent" used herein refers to a compound that includes an aziridine group as a cross-linkable group.

Examples of the aziridine-based cross-linking agent include diphenylmethane-4,4'-bis(1-aziridinecarboxamide), trimethylolpropane-tri-β-aziridinyl propionate, tetramethylolmethane-tri-p-aziridinyl propionate, toluene-2,4-bis(1-aziridinecarboxamide), triethylenemelamine, bisisophthaloyl-1-(2-methylaziridine), tris-1-(2-methylaziridine)phosphine, trimethylolpropane-tri-P-(2-methylaziridine)propionate, and the like.

Examples of the metal chelate-based cross-linking agent include a chelate compound in which the metal atom is aluminum, zirconium, titanium, zinc, iron, tin, or the like. It is preferable to use an aluminum chelate compound as the

7

metal chelate-based cross-linking agent.

Examples of the aluminum chelate compound include diisopropoxyaluminum monooleyl acetoacetate, monoisopropoxyaluminum bisoleyl acetoacetate, monoisopropoxyaluminum monooleate monoethyl acetoacetate, diisopropoxyaluminum monolauryl acetoacetate, diisopropoxyaluminum monostearyl acetoacetate, diisopropoxyaluminum monoisostearyl acetoacetate, and the like.

These cross-linking agents may be used either alone or in combination.

When forming a cross-linked structure using the cross-linking agent, the cross-linking agent is preferably used in such an amount that the ratio of the cross-linkable group included in the cross-linking agent (or the metal chelate-based cross-linking agent when using the metal chelate-based cross-linking agent) is 0.1 to 5 equivalents, and more preferably 0.2 to 3 equivalents, based on the hydroxyl group and the carboxyl group included in the sealing resin.

When a sealing resin that includes a polymerizable functional group (e.g., (meth)acryloyl group) is used, a cross-linked structure can be formed by utilizing a photoinitiator, a thermal initiator, or the like.

Examples of the photoinitiator include benzophenone, acetophenone, benzoin, benzoin methyl ether, benzoin ethyl ether, benzoin isopropyl ether, benzoin isobutyl ether, benzoin benzoate, methyl benzoin benzoate, benzoin dimethyl ketal, 2,4-diethylthioxanthone, 1-hydroxycyclohexyl phenyl ketone, benzyl diphenyl sulfide, tetramethylthiuram monosulfide, azobisisobutyronitrile, 2-chloroanthraquinone, diphenyl(2,4,6-trimethylbenzoyl)phosphine oxide, and bis(2,4,6-trimethylbenzoyl)phenylphosphine oxide.

Examples of the thermal initiator include hydrogen peroxide; a peroxodisulfuric acid salt such as ammonium peroxodisulfate, sodium peroxodisulfate, and potassium peroxodisulfate; an azo compound such as 2,2'-azobis(2-amidinopropane) dihydrochloride, 4,4'-azobis(4-cyanovaleric acid), 2,2'-azobisisobutyronitrile, and 2,2'-azobis(4-methoxy-2,4-dimethylvaleronitrile); an organic peroxide such as benzoyl peroxide, lauroyl peroxide, peracetic acid, persuccinic acid, di-t-butyl peroxide, t-butyl hydroperoxide, and cumene hydroperoxide; and the like.

These initiators may be used either alone or in combination.

When forming a cross-linked structure using the initiator, the initiator is used in a ratio of 0.1 to 100 parts by mass, and preferably 1 to 100 parts by mass, based on the 100 parts by mass of the sealing resin.

The content of the sealing resin (including a cross-linked structure when a cross-linked structure is formed) in the sealing resin layer is preferably 50 to 100 mass-%, more preferably 55 to 99 mass-%, and still more preferably 60 to 99 mass-%, based on the entire sealing resin layer.

The sealing resin layer further includes a UV absorber.

The light transmittance of the sheet-like sealing material at a wavelength of 370 nm can be easily controlled to be 1 % or less by appropriately determining the content of the UV absorber and the thickness of the sheet-like sealing material taking account of the maximum absorption wavelength and the absorption coefficient of the UV absorber.

It is preferable that the UV absorber have a maximum absorption wavelength ($\lambda_{max}$) within the range from 330 to 370 nm. It is more preferable that the UV absorber have a maximum absorption wavelength ($\lambda_{max}$) within the range from 335 to 365 nm. It is still more preferable that the UV absorber have a maximum absorption wavelength ($\lambda_{max}$) within the range from 340 to 360 nm. It is preferable that the UV absorber have a maximum absorbance of 1.0 to 5.0, more preferably 1.5 to 5.0, and still more preferably 2.0 to 5.0, when the UV absorber is added to the resin in a ratio of 2 %, and the mixture is formed to have a thickness of 20 $\mu$m.

If the maximum absorption wavelength ($\lambda_{max}$) of the UV absorber is less than 330 nm, it may be difficult to control the light transmittance at a wavelength of 370 nm to be 1 % or less. If the maximum absorption wavelength ($\lambda_{max}$) of the UV absorber exceeds 370 nm, it may be difficult to obtain a sheet-like sealing material having a light transmittance at a wavelength of 420 nm of 85 % or more.

Specific examples of the UV absorber include salicylic acids such as phenyl salicylate, p-t-butylphenyl salicylate, and p-octylphenyl salicylate; benzophenones such as 2,4-dihydroxybenzophenone, 2-hydroxy-4-methoxybenzophenone, 2-hydroxy-4-octoxybenzophenone, 2-hydroxy-4-dodecyloxybenzophenone, 2,2'-dihydroxy-4-methoxybenzophenone, 2,2'-dihydroxy-4,4'-dimethoxybenzophenone, and 2-hydroxy-4-methoxy-5-sulfobenzophenone; benzotriazoles such as 2-(2'-hydroxy-5'-methylphenyl)benzotriazole, 2-(2'-hydroxy-5'-t-butylphenyl)benzotriazole, 2-(2'-hydroxy-3',5'-di-t-butylphenyl)benzotriazole, 2-(2'-hydroxy-3'-t-butyl-5'-methylphenyl)-5-chlorobenzotriazole, 2-(2'-hydroxy-3',5'-di-t-butylphenyl)-5-chlorobenzotriazole, 2-(2'-hydroxy-3',5'-di-t-amylphenyl)benzotriazole, and 2-1(2'-hydroxy-3',3",4",5",6"-tetrahydrophthalimidemethyl)-5'-methylphenyllbenzot riazole; hindered amines such as bis(2,2,6,6-tetramethyl-4-piperidyl) sebacate, bis(1,2,2,6,6-pentamethyl-4-piperidyl)sebacate, and bis(1,2,2,6,6-pentamethyl-4-piperidyl)[{3,5-bis(1,1-dimethylethyl)-4-hydroxyphenyl}methyl]butylmalonate; and the like.

These UV absorbers may be used either alone or in combination.

The content of the UV absorber in the sealing resin layer may be appropriately determined taking account of the type of UV absorber. The content of the UV absorber in the sealing resin layer is preferably 0.1 to 50 mass-%, more preferably 0.3 to 30 mass-%, still more preferably 0.5 to 20 mass-%, and particularly preferably 1.0 to 10 mass-%, based on the entire sealing resin layer.

The sealing resin layer may further include a tackifier.

When the sealing resin layer includes the tackifier, it is possible to obtain a sheet-like sealing material that exhibits a still more excellent water barrier capability and still more excellent adhesion.

The tackifier is not particularly limited as long as the tackifier improves the adhesion of the sheet-like sealing material. A known tackifier may be used as the tackifier. Examples of the tackifier include an alicyclic petroleum resin, an aliphatic petroleum resin, a terpene resin, an ester-based resin, a coumarone-indene resin, a rosin-based resin, an epoxy resin, a phenol resin, an acrylic resin, a butyral resin, an olefin resin, a chlorinated olefin resin, a vinyl acetate resin, modified resins and hydrogenated resins thereof, and the like. Among these, an aliphatic petroleum resin, a terpene resin, a rosin ester-based resin, a rosin-based resin, and the like are preferable.

These tackifiers may be used either alone or in combination.

The weight average molecular weight of the tackifier is preferably 100 to 10,000, and more preferably 500 to 5,000.

The softening point of the tackifier is preferably 50 to 160°C, more preferably 60 to 140°C, and still more preferably 70 to 130°C.

A commercially-available product may be used directly as the tackifier. Examples of a commercially-available product that may be used as the tackifier include an aliphatic petroleum resin such as ESCOREZ 1000 series products (manufactured by Exxon Chemical Co., Ltd.), and Quintone A/B/R/CX series products (manufactured by Zeon Corporation); an alicyclic petroleum resin such as Arkon P/M series products (manufactured by Arakawa Chemical Industries, Ltd.), ESCOREZ series products (manufactured by Exxon Chemical Co., Ltd.), EASTOTAC series products (manufactured by Eastman Chemical Company), and IMARV series products (manufactured by Idemitsu Kosan Co., Ltd.); a terpene-based resin such as YS Resin P/A series products (manufactured by Yasuhara Chemical Co., Ltd.), Clearon P series products (manufactured by Yasuhara Chemical Co., Ltd.), and Piccolyte A/C series products (manufactured by Hercules); an ester-based resin such as Foral series products (manufactured by Hercules), Pensel A series products (manufactured by Arakawa Chemical Industries, Ltd.), Ester Gum series products (manufactured by Arakawa Chemical Industries, Ltd.), Super Ester series products (manufactured by Arakawa Chemical Industries, Ltd.), and Pinecrystal series products (manufactured by Arakawa Chemical Industries, Ltd.); and the like.

When the sealing resin layer includes the tackifier, the content of the sealing resin in the sealing resin layer is preferably 0.1 to 40 mass-%, and more preferably 1 to 30 mass-%, based on the entire sealing resin layer.

The sealing resin layer may include an additional component as long as the advantageous effects of the invention are not impaired.

Examples of the additional component include additives such as a silane coupling agent, an antistatic agent, a light stabilizer, an antioxidant, a resin stabilizer, a filler, a pigment, an extender, and a softener.

These additional components may be used either alone or in combination.

When the sealing resin layer includes the additional component, the content of each additional component in the sealing resin layer is preferably 0.01 to 5 mass-%, and more preferably 0.01 to 2 mass-%, based on the entire sealing resin layer.

The thickness of the sealing resin layer is not particularly limited, and may be appropriately determined taking account of the thickness of the desired sheet-like sealing material. The thickness of the sealing resin layer is normally 0.1 to 100 $\mu$m, preferably 1.0 to 80 $\mu$m, and still more preferably 5.0 to 50 $\mu$m.

The sheet-like sealing material according to one embodiment of the invention includes one sealing resin layer, or two or more sealing resin layers. The upper limit of the number of sealing resin layers is not particularly limited, but is normally 10 or less.

When the sheet-like sealing material according to one embodiment of the invention includes two or more sealing resin layers, the sheet-like sealing material may have a configuration in which two or more identical sealing resin layers are stacked, or may have a configuration in which two or more different sealing resin layers are stacked.

The different sealing resin layers may differ in the sealing resin, a component other than the sealing resin, the content thereof, or the like.

A decrease in adhesion may occur when the content of the UV absorber in the sealing resin layer is too high. In such a case, a decrease in adhesion can be reduced or suppressed by producing a laminate that includes two or more sealing resin layers as the sheet-like sealing material. For example, when the sheet-like sealing material has a three-layer structure that includes two outermost layers and an intermediate layer, a decrease in adhesion due to the addition of the UV absorber can be prevented by adding the UV absorber to only the intermediate layer.

It is possible to efficiently obtain a sheet-like sealing material that exhibits an excellent water barrier capability, excellent light resistance, excellent colorlessness, and excellent transparency without showing a decrease in adhesion by stacking two or more sealing resin layers.

The sheet-like sealing material is (i) a sheet-like sealing material consisting of one sealing resin layer, (ii) a sheet-like sealing material consisting of one sealing resin layer and one or two release sheets, (iii) a sheet-like sealing material consisting of two or more sealing resin layers, or (iv) a sheet-like sealing material consisting of two or more sealing resin layers and one or two release sheets.

The sheet-like sealing material according to one embodiment of the invention includes one sealing resin layer, or two or more sealing resin layers, when the sheet-like sealing material is used as a sealing material. Specifically, the sheet-like sealing material according to one embodiment of the invention may include a layer (release sheet) that is removed before use. When the sheet-like sealing material according to one embodiment of the invention includes a release sheet, the water vapor transmission rate and the thickness of the sheet-like sealing material (described later) refer to those of the sheet-like sealing material (sealing resin layer) excluding the release sheet.

A known release sheet may be used as the release sheet. For example, the release sheet may be a release sheet that includes a base, and a release layer that has been subjected to a release treatment using a release agent and is provided on the base.

Examples of the base used to produce the release sheet include a paper base such as glassine paper, coated paper, and high-quality paper; laminated paper obtained by laminating a thermoplastic resin (e.g., polyethylene) on such a paper base; a plastic film formed of a polyethylene terephthalate resin, a polybutyrene terephthalate resin, a polyethylene naphthalate resin, a polypropylene resin, a polyethylene resin, or the like; and the like.

Examples of the release agent include a silicone-based resin, an olefin-based resin, a rubber-based elastomer (e.g., isoprene-based resin and butadiene-based resin), a long-chain alkyl-based resin, an alkyd-based resin, a fluorine-based resin, and the like.

The sheet-like sealing material according to one embodiment of the invention may be produced using an arbitrary method. For example, the sheet-like sealing material according to one embodiment of the invention may be produced using a casting method or an extrusion method.

When producing the sheet-like sealing material according to one embodiment of the invention using a casting method, a resin composition that includes a specific component (e.g., sealing resin) may be prepared, and applied to the release-treated side of a release sheet using a known method, and the resulting film may be dried to obtain a sealing resin layer provided with a release sheet (i.e., the sheet-like sealing material according to one embodiment of the invention provided with a release sheet), for example.

The resin composition may be prepared by appropriately mixing and stirring a specific component, a solvent, and the like using an ordinary method.

Examples of the solvent include an aromatic hydrocarbon-based solvent such as benzene and toluene; an ester-based solvent such as ethyl acetate and butyl acetate; a ketone-based solvent such as acetone, methyl ethyl ketone, and methyl isobutyl ketone; an aliphatic hydrocarbon-based solvent such as n-pentane, n-hexane, and n-heptane; an alicyclic hydrocarbon-based solvent such as cyclopentane and cyclohexane; and the like.

These solvents may be used either alone or in combination.

The solid content in the resin composition is preferably 10 to 60 mass-%, more preferably 10 to 45 mass-%, and still more preferably 15 to 30 mass-%.

The resin composition may be applied using a spin coating method, a spray coating method, a bar coating method, a knife coating method, a roll coating method, a blade coating method, a die coating method, a gravure coating method, or the like.

The film formed by applying the resin composition is dried at 80 to 150 °C for 30 seconds to 5 minutes, for example.

The dried film may be allowed to stand for about 1 week to cure the sealing resin layer. A cross-linked structure can be sufficiently formed by curing the sealing resin layer.

A sheet-like sealing material that includes a release sheet that serves as each outermost layer can be obtained by stacking another release sheet on the sealing resin layer.

A sheet-like sealing material that includes two or more sealing resin layers can be obtained by forming a plurality of sealing resin layers, and stacking the plurality of sealing resin layers so as to be situated opposite to each other.

A sheet-like sealing material that includes two or more sealing resin layers can be obtained by forming a sealing resin layer, applying the resin composition to the sealing resin layer, and drying the resulting film.

When producing the sheet-like sealing material according to one embodiment of the invention using an extrusion method, the sealing resin and an additional component may be dry-blended, and the mixture may be formed into a film using an extrusion film-forming method to obtain a sheet-like sealing material, for example.

In this case, a sheet-like sealing material that includes two or more sealing resin layers can be obtained by utilizing a multi-layer extrusion film-forming method.

When producing the sheet-like sealing material according to one embodiment of the invention using a multi-layer extrusion film-forming method, a known method that is used when producing a coextruded multi-layer film may be used.

The sheet-like sealing material according to one embodiment of the invention exhibits an excellent water barrier capability, excellent light resistance, excellent colorlessness, and excellent transparency. Therefore, the sheet-like sealing material according to one embodiment of the invention may suitably be used when sealing an electronic device (as described later). In particular, the sheet-like sealing material according to one embodiment of the invention may suitably be used as a sealing material for sealing an organic EL device that easily deteriorates due to ultraviolet rays.

2) Sealing sheet

A sealing sheet according to one embodiment of the invention includes a sheet-like sealing material that includes one sealing resin layer, or two or more sealing resin layers, and a gas barrier layer, the sheet-like sealing material being the sheet-like sealing material according to one embodiment of the invention.

The gas barrier layer included in the sealing sheet according to one embodiment of the invention is not particularly limited. Examples of the gas barrier layer include a gas barrier layer obtained by subjecting an inorganic film or a layer that includes a polymer compound to an ion implantation treatment, a plasma treatment, a UV irradiation treatment, or the like. The term "gas barrier layer" used herein refers to a layer that does not easily allow gas (e.g., air, oxygen, and water vapor) to pass through.

The inorganic film is not particularly limited. Examples of the inorganic film include an inorganic deposited (evaporated) film.

Examples of the inorganic deposited film include an inorganic deposited film obtained by depositing an inorganic compound, and an inorganic deposited film obtained by depositing a metal.

Examples of the inorganic compound used as the raw material for forming the inorganic deposited film include an inorganic oxide such as silicon oxide, aluminum oxide, magnesium oxide, zinc oxide, indium oxide, and tin oxide; an inorganic nitride such as silicon nitride, aluminum nitride, and titanium nitride; an inorganic carbide; an inorganic sulfide; an inorganic oxynitride such as silicon oxynitride; an inorganic oxycarbide; an inorganic carbonitride; an inorganic oxycarbonitride; and the like.

Examples of the raw material for forming the metal deposited film include aluminum, magnesium, zinc, tin, and the like.

These raw materials may be used either alone or in combination.

An inorganic deposited film that is formed using an inorganic oxide, an inorganic nitride, or a metal as the raw material is preferable from the viewpoint of gas barrier capability. An inorganic deposited film that is formed using an inorganic oxide or an inorganic nitride as the raw material is preferable from the viewpoint of transparency.

The inorganic deposited film may be formed using a physical vapor deposition (PVD) method such as a vacuum deposition method, a sputtering method, or an ion plating method, or a chemical vapor deposition (CVD) method such as a thermal CVD method, a plasma CVD method, or a photo-CVD method, for example.

Examples of the polymer compound that is used to form the layer that includes a polymer compound (hereinafter may be referred to as "polymer layer") include a polyimide, a polyamide, a polyamide-imide, a polyphenylene ether, polyetherketone, polyetheretherketone, a polyolefin, a polyester, a polycarbonate, a polysulfone, polyethersulfone, polyphenylene sulfide, a polyarylate, an acrylic-based resin, a cycloolefin-based polymer, an aromatic polymer, a silicon-containing polymer compound, and the like. These polymer compounds may be used either alone or in combination.

Among these, a silicon-containing polymer compound is preferable since a gas barrier layer that exhibits an excellent gas barrier capability can be formed. A known silicon-containing polymer compound may be used as the silicon-containing polymer compound. Examples of the silicon-containing polymer compound include a polysilazane compound, a polycarbosilane compound, a polysilane compound, a polyorganosiloxane compound, and the like. Among these, a polysilazane compound is preferable.

The polysilazane compound is a polymer compound that includes a repeating unit represented by -Si-N- in the molecule. Examples of the polysilazane compound include an organic polysilazane, an inorganic polysilazane, a modified polysilazane, and the like.

A product commercially available as a glass coating material or the like may be used directly as the polysilazane compound.

These polysilazane compounds may be used either alone or in combination.

The polymer layer may include an additional component other than the polymer compound as long as the object of the invention is not impaired. Examples of the additional component include a curing agent, an additional polymer, an aging preventive, a light stabilizer, a flame retardant, and the like.

The polymer layer may be formed by applying a layer-forming solution that includes at least one polymer compound, an optional additional component, a solvent, and the like using a known device (e.g., spin coater, knife coater, or gravure coater), and appropriately drying the resulting film, for example.

Examples of ions that are implanted into the inorganic film or the polymer layer include ions of a rare gas such as argon, helium, neon, krypton, and xenon; ions of a fluorocarbon, hydrogen, nitrogen, oxygen, carbon dioxide, chlorine, fluorine, sulfur, and the like; ions of alkane-based gases such as methane and ethane; ions of alkene-based gases such as ethylene and propylene; ions of alkadiene-based gases such as pentadiene and butadiene; ions of alkyne-based gases such as acetylene; ions of aromatic hydrocarbon-based gases such as benzene and toluene; ions of cycloalkane-based gases such as cyclopropane; ions of cycloalkene-based gases such as cyclopentene; ions of a metal; ions of an organosilicon compound; and the like.

These ions may be used either alone or in combination.

It is preferable to use ions of a rare gas such as argon, helium, neon, krypton, or xenon due to the ease of ion implantation and a capability to form a gas barrier layer that exhibits a particularly excellent gas barrier capability.

A method of implants ions is not particularly limited. For example, the ions may be implanted using a method that applies ions (ion beams) accelerated by utilizing an electric field, a method that implants ions included in a plasma (plasma ion implantation method), or the like. It is preferable to use the plasma ion implantation method since a gas barrier film can be easily obtained. The plasma ion implantation method generates a plasma in an atmosphere that includes a plasma-generating gas, and implants ions (cations) included in the plasma into the surface area of the inorganic film or the polymer layer by applying a negative high-voltage pulse to the inorganic film or the polymer layer.

The thickness of the gas barrier layer included in the sealing sheet according to one embodiment of the invention is not particularly limited. The thickness of the gas barrier layer is normally 10 to 2,000 nm, preferably 20 to 1,000 nm, more preferably 30 to 500 nm, and still more preferably 40 to 200 nm, from the viewpoint of gas barrier capability and handling capability.

The gas barrier layer may be provided (formed) at an arbitrary position. The gas barrier layer may be formed directly on the sealing resin layer, or may be formed on the sealing resin layer through an additional layer.

Examples of the sealing sheet according to one embodiment of the invention include a sealing sheet that includes a sheet-like sealing material that includes one sealing resin layer, or two or more sealing resin layers, and a gas barrier film, the sheet-like sealing material being the sheet-like sealing material according to one embodiment of the invention.

The gas barrier film includes a base film, and a gas barrier layer that is formed on the base film either directly or through an additional layer.

When the sealing sheet includes the sheet-like sealing material (that includes one sealing resin layer, or two or more sealing resin layers) and the gas barrier film, it is preferable that the sheet-like sealing material be stacked on the side of the gas barrier film that is formed by the gas barrier layer.

A film formed of a resin (e.g., polyimide, polyamide, polyamide-imide, polyphenylene ether, polyetherketone, polyetheretherketone, polyolefin, polyester, polycarbonate, polysulfone, polyethersulfone, polyphenylene sulfide, polyarylate, acrylic-based resin, cycloolefin-based polymer, aromatic-based polymer, or polyurethane-based polymer) may be used as the base film.

The thickness of the base film is not particularly limited, but is preferably 0.5 to 500 $\mu$m, more preferably 1 to 200 $\mu$m, and still more preferably 5 to 100 $\mu$m, from the viewpoint of ease of handling.

Examples of the gas barrier layer included in the gas barrier film include those mentioned above.

The gas barrier layer may include a single layer, or may include a plurality of layers.

The gas barrier film may further include an additional layer such as a protective layer, a conductive layer, or a primer layer. These layers may be provided (stacked) at an arbitrary position.

The water vapor transmission rate of the gas barrier film at a temperature of 40 °C and a relative humidity of 90 % is preferably 0.1 g/(m$^2$·day) or less, more preferably 0.05 g/(m$^2$·day) or less, and still more preferably 0.005 g/(m$^2$·day) or less.

When the water vapor transmission rate is 0.1 g/(m$^2$·day) or less, it is possible to sufficiently reduce the amount of water that passes through each side of the sheet-like sealing material.

The water vapor transmission rate of the gas barrier film may be measured using a known gas transmission rate measurement device.

The total light transmittance of the gas barrier film is preferably 80 % or more, and more preferably 85 % or more.

When the total light transmittance of the gas barrier film is 80 % or more, the sealing sheet according to one embodiment of the invention can suitably be used as a sealing material for a device which is formed on a transparent substrate and for which transparency is required.

The thickness of the gas barrier layer included in the gas barrier film is not particularly limited. The thickness of the gas barrier layer is normally 10 to 2,000 nm, preferably 20 to 1,000 nm, more preferably 30 to 500 nm, and still more preferably 40 to 200 nm, from the viewpoint of gas barrier capability and handling capability.

The sealing sheet according to one embodiment of the invention may be produced using the gas barrier film as described below (see the following production methods 1 and 2).

Production method 1

A release sheet is provided. A resin composition for forming the sealing resin layer is applied to the release-treated side of the release sheet, and the resulting film is dried to obtain a sheet-like sealing material provided with a release sheet (i.e., the sheet-like sealing material according to one embodiment of the invention provided with a release sheet). The sheet-like sealing material provided with a release sheet and the gas barrier film are stacked one on top of another to obtain a sealing sheet provided with a release sheet.

The sheet-like sealing material provided with a release sheet and the gas barrier film may be stacked one on top of another using an arbitrary method. For example, the sheet-like sealing material provided with a release sheet and the gas barrier film may be stacked one on top of another by placing the sheet-like sealing material provided with a release sheet and the gas barrier film one on top of another, and pressing the laminate using a roller or the like. The laminate may be pressed at room temperature, or may be pressed with heating. The heating temperature when pressing the laminate is not particularly limited, but is normally 150 °C or less.

Production method 2

The gas barrier film is provided. A resin composition for forming the sealing resin layer is applied to the gas barrier layer of the gas barrier film using a known method, and the resulting film is dried to form a sheet-like sealing material to obtain the desired sealing sheet. After forming the sealing sheet, a release sheet may be stacked on the sheet-like sealing material in order to protect the sheet-like sealing material of the sealing sheet to obtain a sealing sheet provided with a release sheet.

Examples of the resin composition for forming the sealing resin layer used when implementing the production methods 1 and 2, the method for applying the resin composition, the drying conditions, and the like include those mentioned above in connection with the sheet-like sealing material.

A sheet-like sealing material that includes a plurality of sealing resin layers may be formed in the same manner as described above in connection with the method for producing the sheet-like sealing material according to one embodiment of the invention.

The sealing sheet according to one embodiment of the invention includes the sheet-like sealing material that exhibits an excellent water barrier capability, excellent light resistance, excellent colorlessness, and excellent transparency. Therefore, the sheet-like sealing material according to one embodiment of the invention may suitably be used when sealing an electronic device. In particular, the sheet-like sealing material according to one embodiment of the invention may suitably be used as a sealing material for sealing an organic EL device that easily deteriorates due to ultraviolet rays.

3) Sealed electronic device

A sealed electronic device according to one embodiment of the invention includes the sheet-like sealing material according to one embodiment of the invention or the sealing sheet according to one embodiment of the invention, and an electronic device that is sealed with the sheet-like sealing material or the sealing sheet.

Examples of the sealed electronic device according to one embodiment of the invention include a sealed electronic device that includes a transparent substrate, a device that is formed on the transparent substrate, and a sealing material that seals the device, the sealing material being the sheet-like sealing material according to one embodiment of the invention, and a sealed electronic device that includes a transparent substrate, a device that is formed on the transparent substrate, and a sealing sheet that is stacked to cover the device, the sealing sheet being the sealing sheet according to one embodiment of the invention.

Examples of the electronic device include an organic device such as an organic transistor, an organic memory, and an organic EL device; a liquid crystal display; electronic paper; a thin film transistor; an electrochromic device; an electrochemical light-emitting device; a touch panel; a solar cell; a thermoelectric conversion device; a piezoelectric conversion device; an electrical storage device; and the like.

Examples of the device include a photoelectric conversion device such as a device that converts electrical energy into light (e.g., light-emitting diode and semiconductor laser), and a device that converts light into electrical energy (e.g., photodiode and solar cell); a light-emitting device such as an organic EL device; and the like.

The type, the size, the shape, the number, and the like of the device(s) formed on the transparent substrate are not particularly limited.

The transparent substrate on which the device is formed is not particularly limited. Various substrate materials may be used. In particular, it is preferable to use a substrate material having high visible light transmittance. It is preferable to use a material that exhibits a high barrier capability to prevent entry of water and gas from the outside of the device, and exhibits excellent solvent resistance and excellent weatherability. Specific examples of such a material include a transparent inorganic material such as quartz and glass; a transparent plastic such as polyethylene terephthalate, polyethylene naphthalate, a polycarbonate, polystyrene, polyethylene, polypropylene, polyphenylene sulfide, polyvinylidene fluoride, acetyl cellulose, phenoxy bromide, aramids, polyimides, polystyrenes, polyarylates, polysulfones, and polyolefins; and the like.

The thickness of the transparent substrate is not particularly limited, and may be appropriately selected taking account of the light transmittance and barrier capability.

A transparent conductive layer may be provided on the transparent substrate. The sheet resistance of the transparent conductive (electrode) layer is preferably 500 $\Omega$/sq. or less, and more preferably 100 $\Omega$/sq. or less.

A known material may be used as a material for forming the transparent conductive layer. Specific example of the material for forming the transparent conductive layer include indium tin oxide (ITO), fluorine-doped tin(IV) oxide ($SnO_2$) (FTO), tin(IV) oxide ($SnO_2$), zinc(II) oxide (ZnO), indium zinc oxide (IZO), and the like.

These materials may be used either alone or in combination.

The electronic device may be sealed using the sheet-like sealing material according to one embodiment of the invention or the sealing sheet according to one embodiment of the invention by placing the sheet-like sealing material according to one embodiment of the invention or the sealing sheet according to one embodiment of the invention on the electronic device, optionally placing the gas barrier film or the like thereon, and thermocompression-bonding the laminate.

The sealed electronic device according to one embodiment of the invention has a structure in which the electronic device is sealed using the sheet-like sealing material according to one embodiment of the invention or the sealing sheet according to one embodiment of the invention. Therefore, the sealed electronic device according to one embodiment of the invention rarely shows a deterioration in performance due to entry of water or ultraviolet rays. When the sealed electronic device is configured to emit light, the sealed electronic device can emit light that has substantially the same hue as that of light emitted in an unsealed state.

4) Organic EL device

An organic EL device according to one embodiment of the invention includes a transparent substrate, a first electrode, an organic EL layer, a second electrode, a sheet-like sealing material that includes one sealing resin layer, or two or more sealing resin layers, and a sealing base, the first electrode, the organic EL layer, the second electrode, the sheet-like sealing material, and the sealing base being sequentially stacked on the transparent substrate, and the sheet-like sealing material being the sheet-like sealing material according to one embodiment of the invention.

A known material and the like may be used for the transparent substrate, the first electrode, the organic EL layer, the second electrode, and the sealing base included in the organic EL device according to one embodiment of the invention. In particular, it is preferable to use the transparent substrate or the gas barrier film described above as the sealing base.

The organic EL device according to one embodiment of the invention can be produced (formed) using the sheet-like sealing material according to one embodiment of the invention or the sealing sheet according to one embodiment of the invention.

A production method of the organic EL device according to one embodiment of the invention is not particularly limited. For example, the organic EL device according to one embodiment of the invention may be produced by forming the first electrode, the organic EL layer, and the second electrode on the transparent substrate using a known method, placing the sheet-like sealing material according to one embodiment of the invention thereon, placing the sealing base on the sheet-like sealing material, and thermocompression-bonding the laminate. The organic EL device according to one embodiment of the invention may also be produced by forming the first electrode, the organic EL layer, and the second electrode on the transparent substrate using a known method, and stacking the sealing sheet according to one embodiment of the invention thereon.

Since the organic EL device according to one embodiment of the invention includes the sheet-like sealing material according to one embodiment of the invention, the organic EL layer included in the organic EL device according to one embodiment of the invention rarely shows a deterioration in performance due to entry of water or ultraviolet rays. The organic EL device according to one embodiment of the invention also rarely shows a deterioration in emission properties (e.g., luminance, luminous efficiency, and luminous uniformity).

EXAMPLES

The invention is further described below by way of examples. Note that the invention is not limited to the following examples.

The units "parts" and "%" used in connection with the examples respectively refer to "parts by mass" and "mass-%" unless otherwise indicated.

Compounds

The following compounds and materials were used in connection with the examples.

Sealing resin (1): isobutylene-isoprene copolymer ("Exxon Butyl 268" manufactured by Japan Butyl Co., Ltd., number average molecular weight: 260,000, isoprene content: 1.7 mol-%)

Sealing resin (2): maleic anhydride-modified polyolefin resin ("Admer SE731" manufactured by Mitsui Chemicals Inc.)

Sealing resin (3): butyl acrylate-acrylic acid copolymer (butyl acrylate: 90 mol-%, acrylic acid: 10 mol-%, weight average molecular weight: 650,000)

Note that the number average molecular weight of the sealing resin (1) and the weight average molecular weight of the sealing resin (3) were determined as standard polystyrene-equivalent values by performing gel permeation chromatography under the following conditions.
Device: HLC-8020 manufactured by Tosoh Corporation
Column: TSK guard column HXL-H, TSK gel GMHXL (×2), and TSK gel G2000HXL (manufactured by Tosoh Corporation)
Column temperature: 40°C
Eluant: tetrahydrofuran
Flow rate: 1.0 mL/min
Isocyanate compound (1): trimethylolpropane-modified tolylene diisocyanate ("CORONATE L" manufactured by Nippon Polyurethane Industry Co., Ltd., ethyl acetate solution, solid content: 75 mass-%)

UV absorber (1): benzotriazole-based UV absorber ("TINUVIN 900" manufactured by BASF, maximum absorption wavelength: 348 nm, absorbance: 1.7)

UV absorber (2): benzotriazole-based UV absorber ("TINUVIN 326" manufactured by BASF, maximum absorption wavelength: 355 nm, absorbance: 2.1)

UV absorber (3): benzotriazole-based UV absorber ("TINUVIN 460" manufactured by BASF, maximum absorption wavelength: 349 nm, absorbance: 4.1)

UV absorber (4): benzotriazole-based UV absorber ("TINUVIN CarboProtect" manufactured by BASF, maximum absorption wavelength: 378 nm, absorbance: 1.2)

Release sheet (1): polyethylene terephthalate film that has been subjected to silicone release treatment ("SP-PET381130" manufactured by Lintec Corporation, thickness: 38 $\mu$m)

Release sheet (2): polyethylene terephthalate film that has been subjected to silicone release treatment ("SP-PET38T103-1" manufactured by Lintec Corporation, thickness: 38 $\mu$m)

Note that the absorbance refers to the maximum absorbance when the UV absorber was added to the sealing resin in a ratio of 2 %, and the mixture was formed to have a thickness of 20 $\mu$m. The resin to which the UV absorber was not added was used as a blank.

Production Example 1: Gas barrier film

A polysilazane compound ("AQUAMIKANL110-20" manufactured by Clariant Japan K.K. (i.e., a coating material including perhydropolysilazane as the main component)) was spin-coated onto a polyethylene terephthalate film ("COSMOSHINE A4100" manufactured by Toyobo Co., Ltd., thickness: 50 $\mu$m) (base film), and the resulting film was heated at 120 °C for 1 minute to form a polysilazane layer including perhydropolysilazane (thickness: 150 nm). Argon (Ar) ions were implanted into the surface of the polysilazane layer using a plasma ion implantation apparatus under the following conditions to form a gas barrier layer. A gas barrier film was thus obtained.
The details of the plasma ion implantation apparatus and the ion implantation conditions used to form the gas barrier layer are as follows.
Plasma ion implantation apparatus
RF power supply: "RF56000" manufactured by JEOL Ltd.
High-voltage pulse power supply: "PV-3-HSHV-0835" manufactured by Kurita Seisakusho Co., Ltd.
Plasma ion implantation conditions
Plasma-generating gas: Ar
Gas flow rate: 100 sccm
Duty ratio: 0.5 %
Applied voltage: -15 kV
RF power supply: frequency: 13.56 MHz, applied electric power: 1,000 W
Chamber internal pressure: 0.2 Pa
Pulse width: 5 $\mu$sec
Treatment time (ion implantation time): 200 sec

Example 1

100 parts of the sealing resin (1) and 6 parts of the UV absorber (1) were dissolved in toluene to prepare a resin composition A having a solid content of 20 %.

The resin composition A was applied to the release-treated side of the release sheet (1) so that the thickness after drying was 20 μm, and the resulting film was dried at 120 °C for 2 minutes to form a sealing resin layer. The release-treated side of the release sheet (2) was bonded to the sealing resin layer to obtain a sheet-like sealing material provided with a release sheet.

Examples 2 to 6 and Comparative Examples 1 to 4

A sheet-like sealing material provided with a release sheet was obtained in the same manner as in Example 1, except that the type and the amount of each component and the thickness after drying were optionally changed as shown in Table 1.

Example 7

100 parts of the sealing resin (2) and 3 parts of the UV absorber (1) were dry-blended, and formed into a sheet-like sealing material having a thickness of 40 μm using an extrusion film-forming method.

Comparative Example 5

1.5 parts of the isocyanate compound (1) and 3 parts of the UV absorber (1) were added to 100 parts of the sealing resin (3), and toluene was added to the mixture to prepare a resin composition having a solid content of 20 %. A sheet-like sealing material provided with a release sheet was obtained in the same manner as in Example 1, except that the resulting resin composition was used.

Example 8

A resin composition B was prepared in the same manner as in Example 1, except that the UV absorber (1) was not used.
The resin composition B was applied to the release-treated side of the release sheet (1) so that the thickness after drying was 5 μm, and the resulting film was dried at 120 °C for 2 minutes to form a sealing resin layer. Note that two sealing resin layers (sealing resin layer 1 and sealing resin layer 3) were used in the subsequent stacking step.
A resin composition was prepared in the same manner as in Example 1, except that the type and the amount of each component and the thickness after drying were optionally changed as shown in Table 3. The resulting resin composition was applied to the release-treated side of the release sheet (1) so that the thickness after drying was 40 μm, and the resulting film was dried at 120 °C for 2 minutes to form a sealing resin layer 2. The release-treated side of the release sheet (2) was bonded to the sealing resin layer 2 to obtain a sealing resin layer 2 provided with a release sheet.
The release sheet (1) was removed from the sealing resin layer 2 provided with a release sheet to expose the sealing resin layer 2, and the sealing resin layer 1 was bonded to the exposed sealing resin layer 2. The release sheet (2) was then removed from the sealing resin layer 2 provided with a release sheet to expose the sealing resin layer 2, and the sealing resin layer 3 was bonded to the exposed sealing resin layer 2 to obtain a sheet-like sealing material having a three-layer structure (sealing resin layer 1 (thickness: 5 μm)/sealing resin layer 2 (thickness: 40 μm)/sealing resin layer 3 (thickness: 5 μm)).

Example 9

100 parts of the sealing resin (2) and 3 parts of the UV absorber (1) were dry-blended. The sealing resin (2) was also provided, and a sheet-like sealing material having a three-layer structure (sealing resin layer 1 (thickness: 5 μm, layer formed only of the sealing resin (2))/sealing resin layer 2 (thickness: 40 μm, layer formed of the sealing resin (2) and the UV absorber (1))/sealing resin layer 3 (thickness: 5 μm, layer formed only of the sealing resin (2))) was formed using a multi-layer extrusion film-forming method.
The sealing materials obtained in Examples 1 to 9 and Comparative Examples 1 to 5 were subjected to the following measurements.

Measurement of water vapor transmission rate

The sheet-like sealing material from which the release sheet had been removed, or the resulting sheet-like sealing material (Examples 7 and 9), was sandwiched between two polyethylene terephthalate films (manufactured by Mitsubishi Plastics Inc., thickness: 6 μm) to obtain a water vapor transmission rate measurement sample. The water vapor transmission rate of the sealing material was measured at a temperature of 40 °C and a relative humidity of 90 % using a water vapor transmission rate measurement apparatus ("L80-5000" manufactured by LYSSY).
The water vapor transmission rate at a thickness of 50 μm was calculated from the measurement result using the following expression. The water vapor transmission rate (at a thickness of 50 μm) thus calculated is shown in Tables 1 to 3.

$$\text{Water vapor transmission rate at a thickness of 50 } \mu\text{m} = \text{water vapor transmission rate (measured value)} \times (\text{thickness}/50)$$

Visible light transmittance

The sheet-like sealing material from which the release sheet had been removed, or the resulting sheet-like sealing material (Examples 7 and 9), was bonded to a glass sheet ("Corning Glass Eagle XG" manufactured by NSG Precision Co., Ltd., 150×70×2 mm) with heating to obtain a measurement sample consisting of the sheet-like sealing material and the glass sheet.
The light transmittance of the sample was measured using a spectrophotometer ("UV-3101PC" manufactured by Shimadzu Corporation).
The light transmittance at a wavelength of 370 nm and the light transmittance at a wavelength of 420 nm thus measured are shown in Tables 1 to 3.

Evaluation of hue

A measurement sample was prepared in the same manner as the visible light transmittance measurement sample.
The b* value of the sample (defined by the CIE 1976 L*a*b* color system) was measured in accordance with JIS Z 8729-1994 using a spectrophotometer ("MPC3100" manufactured by Shimadzu Corporation).
The measurement results are shown in Tables 1 to 3.

Measurement of adhesion

The sheet-like sealing material from which the release sheet had been removed, or the resulting sheet-like sealing material (Examples 7 and 9), was bonded to a polyethylene terephthalate film, and the resulting laminate was cut to have a size of 25×300 mm. The laminate thus cut was bonded (compression-bonded) to a glass sheet (soda lime glass, manufactured by Nippon Sheet Glass Co., Ltd.) with heating at a temperature of 23 °C and a relative humidity of 50 % to obtain a measurement sample.
After allowing the measurement sample to stand at a temperature of 23 °C and a relative humidity of 50 % for 24 hours, the measurement sample was subjected to a peel test at a temperature of 23 °C and a relative humidity of 50 % using a tensile tester ("Tensilon" manufactured by Orientec Co., Ltd.) (peel rate: 300 mm/min, peel angle: 180°) to measure the adhesion (N/25 mm) of the sheet-like sealing material.
The measurement results are shown in Tables 1 to 3.

Evaluation of light resistance

The sheet-like sealing material from which the release sheet had been removed, or the resulting sheet-like sealing material (Examples 7 and 9), was sandwiched between two glass sheets to obtain a measurement sample. The measurement sample was placed on a polyethylene terephthalate film to obtain a laminate having a "polyethylene terephthalate film/glass sheet/sheet-like sealing material/glass sheet" layer structure.
Ultraviolet rays (irradiance: 900 W/m²) were applied to the laminate for 100 hours through the glass sheet at a temperature of 63 °C and a relative humidity of 70 % using a weather meter ("EYE Super UV tester SUV-13 "manufactured by Iwasaki Electric Co., Ltd.).
The b* value of the polyethylene terephthalate film was then measured in the same manner as described above (see "Evaluation of hue"), and the weatherability was evaluated in accordance with the following standard. The evaluation results are shown in Tables 1 to 3.
Good: The b* value was less than 2.
Bad: The b* value was 2 or more.

Evaluation of durability of organic EL device

A glass substrate was subjected to a solvent cleaning treatment and a UV/ozone treatment, and aluminum (Al) (manufactured by Kojundo Chemical Lab. Co., Ltd.) (100 nm) was deposited on the surface of the glass substrate at a deposition rate of 0.1 nm/s to form a cathode.

(8-Hydroxyquinolinato)lithium (manufactured by Luminescence Technology) (10 nm), 2,9-dimethyl-4,7-diphenyl-1,10-phenanthroline (manufactured by Luminescence Technology) (10 nm), tris(8-hydroxyquinolinato)aluminum (manufactured by Luminescence Technology) (40 nm), and N,N'-bis(naphthalen-1-yl)-N,N'-bis(phenyl)-benzidine (manufactured by Luminescence Technology) (60 nm) were sequentially deposited on the cathode (Al film) at a deposition rate of 0.1 to 0.2 nm/s to form an emitting layer.

An indium tin oxide (ITO) film (thickness: 100 nm, sheet resistance: 50 $\Omega$/sq.) was formed on the emitting layer using a sputtering method to form an anode to obtain an organic EL device. Note that the degree of vacuum during deposition was set to $1\times10^{-4}$ Pa or less.

The sheet-like sealing material from which the release sheet had been removed, or the resulting sheet-like sealing material (Examples 7 and 9), was heated and dried at 120 °C for 10 minutes in a nitrogen atmosphere using a hot plate, and allowed to cool to room temperature.

The sheet-like sealing material was placed to cover the organic EL device formed on the glass substrate. After placing the gas barrier film on the sheet-like sealing material, the laminate was compression-bonded at room temperature (Examples 1 to 6 and Comparative Examples 1 to 5) or 100 °C (Examples 7 and 9) to seal the organic EL device to obtain a top-emission electronic device.

The organic EL device was allowed to stand at a temperature of 23 °C and a relative humidity of 50 % for 50 hours, and driven to observe the presence or absence of a dark spot (i.e., an area in which light was not emitted). The durability of the organic EL device was evaluated in accordance with the following standard. The evaluation results are shown in Tables 1 to 3.

Evaluation standard

Good: The ratio of a dark spot area was less than 10 % with respect to the emission area.
Bad: The ratio of a dark spot area was 10 % or more with respect to the emission area.

TABLE 1

| | | Example | | | | | | |
|---|---|---|---|---|---|---|---|---|
| | | 1 | 2 | 3 | 4 | 5 | 6 | 7 |
| Number of sealing resin layers | | 1 | 1 | 1 | 1 | 1 | 1 | 1 |
| Sealing resin layer | Sealing resin Content (parts) | (1) 100 | (1) 100 | (1) 100 | (1) 100 | (1) 100 | (1) 100 | (2) 100 |
| | UV absorber Content (parts) | (1) 6.0 | (1) 3.0 | (1) 1.5 | (2) 1.3 | (2) 3.0 | (3) 3.0 | (1) 3.0 |
| | Thickness ($\mu$m) | 20 | 40 | 80 | 40 | 40 | 40 | 40 |
| Water vapor transmission rate (thickness: 50 $\mu$m) (g/(m$^2$·day)) | | 3.0 | 2.8 | 2.7 | 2.8 | 2.8 | 2.8 | 19.0 |
| Light transmittance (370 nm) (%) | | 0.3 | 0.3 | 0.3 | 0.9 | 0 | 0.3 | 0.2 |
| Light transmittance (420 nm) (%) | | 91 | 91 | 91 | 90 | 88 | 91 | 90 |
| Evaluation of hue b* | | 0.4 | 0.5 | 0.5 | 0.6 | 0.9 | 0.5 | 0.5 |
| Evaluation of hue a* | | -0.4 | -0.4 | -0.5 | -0.4 | -0.5 | -0.4 | -0.4 |
| Adhesion (N/25 mm) | | 3.2 | 4.5 | 5.3 | 4.4 | 4.4 | 4.5 | 46.1 |
| Evaluation of light resistance | | Good | Good | Good | Good | Good | Good | Good |

(continued)

| | Example | | | | | | |
|---|---|---|---|---|---|---|---|
| | 1 | 2 | 3 | 4 | 5 | 6 | 7 |
| Evaluation of durability of organic EL device | Good | Good | Good | Good | Good | Good | Good |

TABLE 2

| | | Comparative Example | | | | |
|---|---|---|---|---|---|---|
| | | 1 | 2 | 3 | 4 | 5 |
| | Number of sealing resin layers | 1 | 1 | 1 | 1 | 1 |
| Sealing resin layer | Sealing resin Content (parts) | (1) 100 | (1) 100 | (1) 100 | (1) 100 | (3) 100 |
| | UV absorber Content (parts) | - | (1) 1.5 | (1) 30 | (4) 3.0 | (1) 3.0 |
| | Thickness ($\mu$m) | 40 | 40 | 40 | 40 | 40 |
| Water vapor transmission rate (thickness: 50 $\mu$m) (g/(m$^2$·day)) | | 2.8 | 2.8 | - | 2.9 | 115 |
| Light transmittance (370 nm) (%) | | 90 | 3.8 | - | 0 | 0.3 |
| Light transmittance (420 nm) (%) | | 91 | 91 | - | 13 | 91 |
| Evaluation of hue b* | | 0.3 | 0.3 | - | 29 | 0.5 |
| Evaluation of hue a* | | -0.3 | -0.3 | - | -3.6 | -0.4 |
| Adhesion (N/25 mm) | | 4.6 | 4.4 | - | 4.4 | 10.2 |
| Evaluation of light resistance | | Bad | Bad | - | Good | Good |
| Evaluation of durability of organic EL device | | Good | Good | - | - | Bad |

TABLE 3

| | | Example | |
|---|---|---|---|
| | | 8 | 9 |
| | Number of sealing resin layers | 3 | 3 |
| Sealing resin layer 1 | Sealing resin Content (parts) | (1) 100 | (2) 100 |
| | UV absorber Content (parts) | - | - |
| | Thickness ($\mu$m) | 5 | 5 |
| Sealing resin layer 2 | Sealing resin Content (parts) | (1) 100 | (2) 100 |
| | UV absorber Content (parts) | (1) 3 | (3) 3 |
| | Thickness ($\mu$m) | 40 | 40 |
| Sealing resin layer 3 | Sealing resin Content (parts) | (1) 100 | (2) 100 |
| | UV absorber Content (parts) | - | - |
| | Thickness ($\mu$m) | 5 | 5 |
| Water vapor transmission rate (thickness: 50 $\mu$m) (g/(m$^2$·day)) | | 2.8 | 19.0 |
| Light transmittance (370 nm) (%) | | 0.4 | 0.3 |
| Light transmittance (420 nm) (%) | | 91 | 90 |
| Evaluation of hue b* | | 0.5 | 0.5 |
| Evaluation of hue a* | | -0.4 | -0.4 |

(continued)

|  | Example | |
| --- | --- | --- |
|  | 8 | 9 |
| Adhesion (N/25 mm) | 4.6 | 48.5 |
| Evaluation of light resistance | Good | Good |
| Evaluation of durability of organic EL device | Good | Good |

The following were confirmed from the results shown in Tables 1 to 3.

The sheet-like sealing materials of Examples 1 to 9 had a water vapor transmission rate of 20 g/(m²·day) or less, a b* value of -2 to 2, a light transmittance at a wavelength of 370 nm of 1 % or less, and a light transmittance at a wavelength of 420 nm of 85 % or more. As a result, the sheet-like sealing materials of Examples 1 to 9 exhibited an excellent water barrier capability, excellent light resistance, excellent colorlessness, and excellent transparency. The sheet-like sealing materials of Examples 1 to 9 also exhibited sufficient adhesion, and the organic EL devices produced using the sheet-like sealing materials of Examples 1 to 9 exhibited excellent durability.

On the other hand, the sheet-like sealing materials of Comparative Examples 1 and 2 exhibited poor light resistance.

A film (sheet-like sealing material) could not be formed using the resin composition of Comparative Example 3 since the amount of UV absorber was too large (i.e., the UV absorber could not be dispersed).

The sheet-like sealing material of Comparative Example 4 had a large b* value (i.e., the degree of yellow was high).

The organic EL device produced using the sheet-like sealing material of Comparative Example 5 exhibited poor durability.

**Claims**

1. A sheet-like sealing material comprising one sealing resin layer, or two or more sealing resin layers, the sheet-like sealing material having a water vapor transmission rate at a temperature of 40 °C and a relative humidity of 90 % of 20 g/(m²·day) or less when the sheet-like sealing material has a thickness of 50 μm, having a b* value in a CIE L*a*b* color system defined by JIS Z 8729-1994 of -2 to 2, having a light transmittance at a wavelength of 370 nm of 1 % or less, and having a light transmittance at a wavelength of 420 nm of 85 % or more, wherein the sheet-like sealing material is (i) a sheet-like sealing material consisting of one sealing resin layer, (ii) a sheet-like sealing material consisting of one sealing resin layer and one or two release sheets, (iii) a sheet-like sealing material consisting of two or more sealing resin layers, or (iv) a sheet-like sealing material consisting of two or more sealing resin layers and one or two release sheets, the sheet-like sealing material has a thickness of 0. 1 to 100 μm, the sheet-like sealing material has an adhesion to glass at a temperature of 23 °C and a relative humidity of 50 % of 3 N/25 mm or more, the sealing resin layer comprises at least one material selected from the group consisting of a rubber-based polymer and a polyolefin-based polymer, and at least one of the sealing resin layers comprises a UV absorber:

2. The sheet-like sealing material according to claim 1, wherein the UV absorber has a maximum absorption wavelength within a range from 330 to 370 nm.

3. The sheet-like sealing material according to claim 1, the sheet-like sealing material being used to seal an electronic device.

4. A sealing sheet comprising a sheet-like sealing material that comprises one sealing resin layer, or two or more sealing resin layers, and a gas barrier layer, the sheet-like sealing material being the sheet-like sealing material according to claim 1.

5. The sealing sheet according to claim 4, comprising the sheet-like sealing material, and a gas barrier film in which the gas barrier layer is formed on a base film either directly or through an additional layer.

6. The sealing sheet according to claim 4, the sealing sheet being used to seal an electronic device.

7. A sealed electronic device comprising the sheet-like sealing material according to claim 1, or the sealing sheet according to claim 4, and an electronic device that is sealed with the sheet-like sealing material or the sealing sheet.

8. An organic EL device comprising a transparent substrate, a first electrode, an organic EL layer, a second electrode, a sheet-like sealing material that comprises one sealing resin layer, or two or more sealing resin layers, and a sealing base, the first electrode, the organic EL layer, the second electrode, the sheet-like sealing material, and the sealing base being sequentially stacked on the transparent substrate, the sheet-like sealing material being the sheet-like sealing material according to claim 1.

**Patentansprüche**

1. Bahnförmiges Dichtungsmaterial, umfassend eine Dichtungsharzschicht oder zwei oder mehr Dichtungsharzschichten, wobei das bahnförmige Dichtungsmaterial eine Wasserdampfdurchlässigkeitsrate bei einer Temperatur von 40°C und einer relativen Feuchtigkeit von 90% von 20 g/ ($m^2$·Tag) oder weniger aufweist, wenn das bahnförmige Dichtungsmaterial eine Dicke von 50 $\mu$m aufweist, einen ab*-Wert in einem CIE-L*a*b*-Farbsystem, das durch JIS Z 8729-1994 definiert ist, von -2 bis 2 aufweist, eine Lichtdurchlässigkeit bei einer Wellenlänge von 370 nm von 1% oder weniger aufweist und eine Lichtdurchlässigkeit bei einer Wellenlänge von 420 nm von 85% oder mehr aufweist, wobei das bahnförmige Dichtungsmaterial (i) ein bahnförmiges Dichtungsmaterial ist, das aus einer Dichtungsharzschicht besteht, (ii) ein bahnförmiges Dichtungsmaterial ist, das aus einer Dichtungsharzschicht und einer oder zwei Trennbahn(en) besteht, (iii) ein bahnförmiges Dichtungsmaterial ist, das aus zwei oder mehreren Dichtungsharzschichten besteht, oder (iv) ein bahnförmiges Dichtungsmaterial ist, das aus zwei oder mehreren Dichtungsharzschichten und einer oder zwei Trennbahn(en) besteht, das bahnförmige Dichtungsmaterial eine Dicke von 0,1 bis 100 $\mu$m aufweist, das bahnförmige Dichtungsmaterial eine Haftung an Glas bei einer Temperatur von 23°C und einer relativen Feuchtigkeit von 50% von 3 N/25 mm oder mehr aufweist, die Dichtungsharzschicht mindestens ein Material, ausgewählt aus der Gruppe, bestehend aus einem Polymer auf Kautschukbasis und einem Polymer auf Polyolefinbasis, umfasst, und mindestens eine der Dichtungsharzschichten einen UV-Absorber umfasst.

2. Bahnförmiges Dichtungsmaterial nach Anspruch 1, wobei der UV-Absorber eine maximale Absorptionswellenlänge in einem Bereich von 330 bis 370 nm aufweist.

3. Bahnförmiges Dichtungsmaterial nach Anspruch 1, wobei das bahnförmige Dichtungsmaterial zum Abdichten einer elektronischen Vorrichtung verwendet wird.

4. Dichtungsbahn, umfassend ein bahnförmiges Dichtungsmaterial, das eine Dichtungsharzschicht oder zwei oder mehrere Dichtungsharzschichten umfasst, und eine Gassperrschicht, wobei das bahnförmige Dichtungsmaterial das bahnförmige Dichtungsmaterial nach Anspruch 1 ist.

5. Dichtungsbahn nach Anspruch 4, umfassend das bahnförmige Dichtungsmaterial und einen Gassperrfilm, wobei die Gassperrschicht entweder direkt oder durch eine zusätzliche Schicht auf einem Basisfilm ausgebildet ist.

6. Dichtungsbahn nach Anspruch 4, wobei die Dichtungsbahn zum Abdichten einer elektronischen Vorrichtung verwendet wird.

7. Abgedichtete elektronische Vorrichtung, umfassend das bahnförmige Dichtungsmaterial nach Anspruch 1 oder die Dichtungsbahn nach Anspruch 4 und eine elektronische Vorrichtung, die mit dem bahnförmigen Dichtungsmaterial oder der Dichtungsbahn abgedichtet ist.

8. Organische EL-Vorrichtung, umfassend ein transparentes Substrat, eine erste Elektrode, eine organische EL-Schicht, eine zweite Elektrode, ein bahnförmiges Dichtungsmaterial, das eine Dichtungsharzschicht oder zwei oder mehrere Dichtungsharzschichten umfasst, und eine Dichtungsbasis, wobei die erste Elektrode, die organische EL-Schicht, die zweite Elektrode, das bahnförmige Dichtungsmaterial und die Dichtungsbasis nacheinander auf dem transparenten Substrat gestapelt sind,
wobei das bahnförmige Dichtungsmaterial das bahnförmige Dichtungsmaterial nach Anspruch 1 ist.

**Revendications**

1. Matériau d'étanchéité de type feuille comprenant une couche de résine d'étanchéité, ou deux couches de résine d'étanchéité ou plus,
le matériau d'étanchéité de type feuille ayant un taux de transmission de vapeur d'eau à une température de 40 °C et une humidité relative de 90 % de 20 g/(m$^2$·jour) ou moins lorsque le matériau d'étanchéité de type feuille a une épaisseur de 50 μm, ayant une valeur b* dans un système de couleur L*a*b* CIE défini par JIS Z 8729-1994 de -2 à 2, ayant une transmittance de lumière à une longueur d'onde de 370 nm de 1 % ou moins, et ayant une transmittance de lumière à une longueur d'onde de 420 nm de 85 % ou plus, dans lequel
le matériau d'étanchéité de type feuille est (i) un matériau d'étanchéité de type feuille constitué d'une couche de résine d'étanchéité, (ii) un matériau d'étanchéité de type feuille constitué d'une couche de résine d'étanchéité et d'une ou deux feuilles détachables, (iii) un matériau d'étanchéité de type feuille constitué de deux couches de résine d'étanchéité ou plus, ou (iv) un matériau d'étanchéité de type feuille constitué de deux couches de résine d'étanchéité ou plus et d'une ou deux feuilles détachables,
le matériau d'étanchéité de type feuille a une épaisseur de 0,1 à 100 μm,
le matériau d'étanchéité de type feuille a une adhérence au verre à une température de 23 °C et une humidité relative de 50 % de 3 N/25 mm ou plus,
la couche de résine d'étanchéité comprend au moins un matériau choisi dans le groupe constitué d'un polymère à base de caoutchouc et d'un polymère à base de polyoléfine, et
au moins une des couches de résine d'étanchéité comprend un absorbeur d'UV.

2. Matériau d'étanchéité de type feuille selon la revendication 1, dans lequel l'absorbeur d'UV a une longueur d'onde d'absorption maximum dans une plage de 330 à 370 nm.

3. Matériau d'étanchéité de type feuille selon la revendication 1, le matériau d'étanchéité de type feuille étant utilisé pour sceller un dispositif électronique.

4. Feuille d'étanchéité comprenant un matériau d'étanchéité de type feuille qui comprend une couche de résine d'étanchéité, ou deux couches de résine d'étanchéité ou plus, et une couche barrière aux gaz,
le matériau d'étanchéité de type feuille étant le matériau d'étanchéité de type feuille selon la revendication 1.

5. Feuille d'étanchéité selon la revendication 4, comprenant le matériau d'étanchéité de type feuille et un film barrière aux gaz dans lequel la couche barrière aux gaz est formée sur un film de base soit directement soit à travers une couche supplémentaire.

6. Feuille d'étanchéité selon la revendication 4, la feuille d'étanchéité étant utilisée pour sceller un dispositif électronique.

7. Dispositif électronique scellé comprenant le matériau d'étanchéité de type feuille selon la revendication 1, ou la feuille d'étanchéité selon la revendication 4, et un dispositif électronique qui est scellé avec le matériau d'étanchéité de type feuille ou la feuille d'étanchéité.

8. Dispositif électroluminescent organique comprenant un substrat transparent, une première électrode, une couche électroluminescente organique, une seconde électrode, un matériau d'étanchéité de type feuille qui comprend une couche de résine d'étanchéité, ou deux couches de résine d'étanchéité ou plus, et une base d'étanchéité, la première électrode, la couche électroluminescente organique, la seconde électrode, le matériau d'étanchéité de type feuille et la base d'étanchéité étant empilés séquentiellement sur le substrat transparent,
le matériau d'étanchéité de type feuille étant le matériau d'étanchéité de type feuille selon la revendication 1.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2013168715 A1
- WO 2012039436 A1
- WO 2010061738 A1
- JP 2006297737 A
- JP H06172742 A
- EP 2737997 A1
- JP 5182759 A

- JP 5101884 A
- JP 2004087153 A
- JP 2004224991 A
- JP 2009524705 T
- WO 2007087281 A
- JP 2009037809 A
- US 20100244073 A1